# EUROPÄISCHE PATENTSCHRIFT

(11) **EP 1 499 902 B1**
(45) Veröffentlichungstag und Bekanntmachung des Hinweises auf die Patenterteilung: **16.05.2007**
(21) Anmeldenummer: 03718716.8
(22) Anmeldetag: 28.03.2003
(51) Int. Cl.: G01R 23/20

(54) **EINRICHTUNG ZUM MESSEN VON INTERMODULATIONSVERZERRUNGEN**
DEVICE FOR MEASURING INTERMODULATION DISTORTION
DISPOSITIF DE MESURE DE DISTORSIONS D'INTERMODULATION

(30) Priorität: 30.04.2002 DE 10219340
(43) Veröffentlichungstag der Anmeldung: 26.01.2005
(73) Patentinhaber: Rohde & Schwarz GmbH & Co. KG, 81671 München (DE)
(72) Erfinder: MINIHOLD, Roland, 80639 München (DE); BEDNORZ, Thilo, 85435 Erding (DE)
(74) Vertreter: Körfer, Thomas
(86) Internationale Anmeldenummer: PCT/EP2003/003286
(87) Internationale Veröffentlichungsnummer: WO 2003/093841

(56) Entgegenhaltungen:
- EP-A- 0 499 346
- US-A- 3 711 769
- US-B1- 6 263 289

## Beschreibung

Die Erfindung betrifft eine Einrichtung zum Messen von Intermodulationsverzerrungen.

Intermodulationsverzerrungen (d3-Intermodulation) besonders in Form von Nachbarkanalleistung (ACPR) sind eine wichtige Spezifikation besonders für Leistungsverstärker, die in Mobilfunk-Basisstationen eingesetzt werden. Dies gilt besonders auch für Leistungsverstärker, die mit mehreren Trägersignalen ausgesteuert werden. Nichtlinearitäten in dem Leistungsverstärker führen zum Übersprechen eines Kanals in die Nachbarkanäle, was sich dort störend auswirkt. Zur Messung der Intermodulationsverzerrungen eines Leistungsverstärkers wird dieser deshalb mit einem Meßsignal in dem Nutzkanal beaufschlagt und die Leistungsanteile in den Nachbarkanälen werden gemessen.

Aus der US 6,263,289 B1 ist bereits eine Einrichtung zum Messen von Intermodulationsverzerrungen an einem Meßobjekt, beispielsweise einem Leistungsverstärker, bekannt. Bei dem aus dieser Druckschrift bekannten Verfahren wird ein Signalgenerator mit dem Eingang des Meßobjekts bzw. DUT (Device Under Test) verbunden. Bei dem Meßobjekt handelt es sich beispielsweise um einen Leistungsverstärker, der mit einem Abschlußwiderstand abgeschlossen ist. Am Eingang und Ausgang des Meßobjekts befindet sich jeweils ein direktionaler Koppler. Das Signal des Kopplers am Ausgang des Meßobjekts wird einem Signalkombinierer (power combiner) direkt zugeführt, während das über den Koppler am Eingang des Meßobjekts abgenommene Signal über ein Netzwerk zur Änderung des Pegels und der Phase dem Signalkombinierer zugeführt wird. Das Netzwerk zur Änderung des Pegels und der Phase dient dazu, das am Eingang des Meßobjekts abgenommene Signal der gleichen Pegel-Phasen-Änderung zu unterwerfen, die das Signal in dem Meßobjekt erfährt, wobei dieser Signalpfad mit einer zusätzlichen Phasenverschiebung von 180° gegenüber dem durch das Meßobjekt führenden Signalpfad beaufschlagt wird. Bei der Messung von Nachbarkanalleistungen (ACPR) werden somit Nachbarkanal-Leistungsanteile, die bereits in dem Eingangssignal des Meßobjekts enthalten sind, kompensiert.

Das aus der US 6,263,289 B1 bekannte Verfahren hat den Nachteil, daß ein Laufzeitausgleich nur im Bereich von einigen 100 ns möglich ist, denn ein größerer Laufzeitausgleich kann durch das Pegel- und Phasenveränderungsnetzwerk nicht ausgeglichen werden. Meßobjekte mit höheren Laufzeiten können deshalb mit den bekannten Verfahren nicht gemessen werden. Außerdem besteht der Nachteil, daß ein mit hinreichender Genauigkeit arbeitendes Pegel- und Phasenänderungsnetzwerk relativ aufwendig gebaut ist, wie Fig. 6 der US 6,263,289 B1 zeigt. Das bekannte Verfahren hat deshalb einen relativ hohen Realisierungsaufwand.

In der EP 0 499 346 A1 sind zwei Signalgeneratoren zur Realisierung des sogenannten 2-Ton-Verfahrens verwendet. Bei dem 2-Ton-Verfahren werden zwei Sinussignale mit sich nur geringfügig unterscheidender Frequenz auf den Eingang eines Meßobjekts gegeben und die durch das Meßobjekt erzeugten Intermodulationsprodukte am Ausgang analysiert. Bei der angegebenen Meßkonfiguration wird das Ausgangssignal des Meßobjekts auf eine Zwischenfrequenz heruntergemischt, digital abgetastet und dann einer Fourier-Transformation unterworfen. In dem Spektrum sind dann die entsprechenden Intermodulationsprodukte erkennbar. Im Unterschied zu der erfindungsgemäßen Konfiguration werden jedoch beide Eingangssignale auf den Eingang des Meßobjekts gegeben, damit die Intermodulationsprodukte entstehen.

In der US-A- 3,711,769 werden die Signale zweier Signalgeneratoren an einem Richtkoppler miteinander kombiniert und über ein Tiefpaßfilter dem Eingang des Meßobjekts zugeführt. Parallel dazu befindet sich ein Bypass, mit einem Phasenverschiebungsnetzwerk.

Der Erfindung liegt die Aufgabe zugrunde, eine Meßeinrichtung zum Messen von Intermodulationsverzerrungen eines Meßobjekts anzugeben, die eine Messung mit erhöhter Genauigkeit auch bei größeren Gruppenlaufzeiten durch das Meßobjekt ermöglicht.

Die Aufgabe wird durch den Gegenstand mit den Merkmalen des Anspruchs 1 gelöst. Die Unteransprüche enthalten vorteilhafte Weiterbildungen der Erfindung.

Der Erfindung liegt die Erkenntnis zugrunde, daß durch die Verwendung von getrennten Signalgeneratoren für das Meßsignal und das Referenzsignal eine wesentlich höhere Meßgenauigkeit bei geringerem Aufwand erreicht werden kann. Bei der erfindungsgemäßen Lösung erzeugt ein erster Signalgenerator das dem Meßobjekt zugeführte Eingangssignal, während ein mit dem ersten Signalgenerator synchronisierter zweiter Signalgenerator das Referenzsignal erzeugt, das dem Signalkombinierer zugeführt wird. Die Gruppenlaufzeit in dem Meßobjekt und die Phasenverschiebung in dem Meßobjekt können durch Vorhalten einer entsprechenden Zeitverzögerung bzw. Phasenverschiebung des mit dem zweiten Signalgenerator erzeugten Referenzsignals in Bezug auf das von dem ersten Signalgenerator erzeugte Meßsignal innerhalb eines relativ großen Rahmens ausgeglichen werden. Auch Laufzeiten durch das Meßobjket im Mikrosekundenbereich, wie sie bei Leistungsverstärkern mit digitaler Feed-Forward-Linearisierung heute vorkommen, können mit dem erfindungsgemäßen Meßverfahren kompensiert werden. Dies ist mit dem aus dem Stand der Technik bekannten Pegel-Phasen-Abstimmnetzwerk nicht oder nur mit sehr großem Aufwand möglich. Außerdem kann der Laufzeitausgleich innerhalb der Bandbreite des Meßsignals frequenzunabhängig, d.h. breitbandig erfolgen. Mit dem erfindungsgemäßen Verfahren wird eine Unterdrückung von unerwünschten Signalkomponenten des Meßsignals um mehr als 26 dB erreicht.

Zumindest einer der Signalgeneratoren ist bezüglich der Zeitverzögerung, der Amplitude sowie der Phasenlage sowohl des Hochfrequenz-Signals als auch des Modulations-Signals, mit welchem das Hochfrequenz-Signal moduliert wird, einstellbar. Sowohl die Phase des Hochfrequenz-Signals als auch des Modulations-Signals werden mit 180° Phasendifferenz zum Ausgangssignal des Meßobjekts eingestellt, so daß es zu einer maximalen Auslöschung der Signale kommt. Die von dem Hochfrequenz-Signal getrennte Phasenkompensation des Modulations-Signals ist bei der Verwendung des aus dem Stand der Technik bekannten Pegel-Phasen-Abstimmnetzwerkes grundsätzlich nicht möglich und stellt einen weiteren erheblichen Vorteil des erfindungsgemäßen Verfahrens dar.

Die Einstellung der Phasenlage des Hochfrequenz-Signals und des Modulations-Signals ist mit sehr kleiner Schrittweite von weniger als 1/50, bevorzugt weniger als 1/100 der Periodendauer möglich, so daß die 180°-Phasenkompensation äußerst exakt eingestellt werden kann. Die Anbindung des Ausgangssignals des Meßobjekts kann entweder über ein Dämpfungsglied, dessen Dämpfungsfaktor so bemessen ist, daß der Signalpegel am Ausgang des Dämpfungsglieds in etwa mit dem Signalpegel am Eingang des Meßobjekts übereinstimmt, oder über einen am Ausgang des Meßobjekts angeordneten Koppler erfolgen, wobei in diesem Fall der Kopplungsfaktor so zu bemessen ist, daß der Signalpegel am Ausgang des Kopplers in etwa mit dem Signalpegel am Eingang des Meßobjekts übereinstimmt.

Ausführungsbeispiele der Erfindung werden nachfolgend unter Bezugnahme auf die Zeichnung näher erläutert. In der Zeichnung zeigen:
- Fig. 1: ein Blockschaltbild eines ersten Ausführungsbeispiels einer erfindungsgemäßen Meßeinrichtung;
- Fig. 2: das Spektrum am Ausgang des Meßobjekts zur Erläuterung der der Erfindung zugrunde liegenden Problematik und
- Fig. 3: ein zweites Ausführungsbeispiel der erfindungsgemäßen Meßeinrichtung.

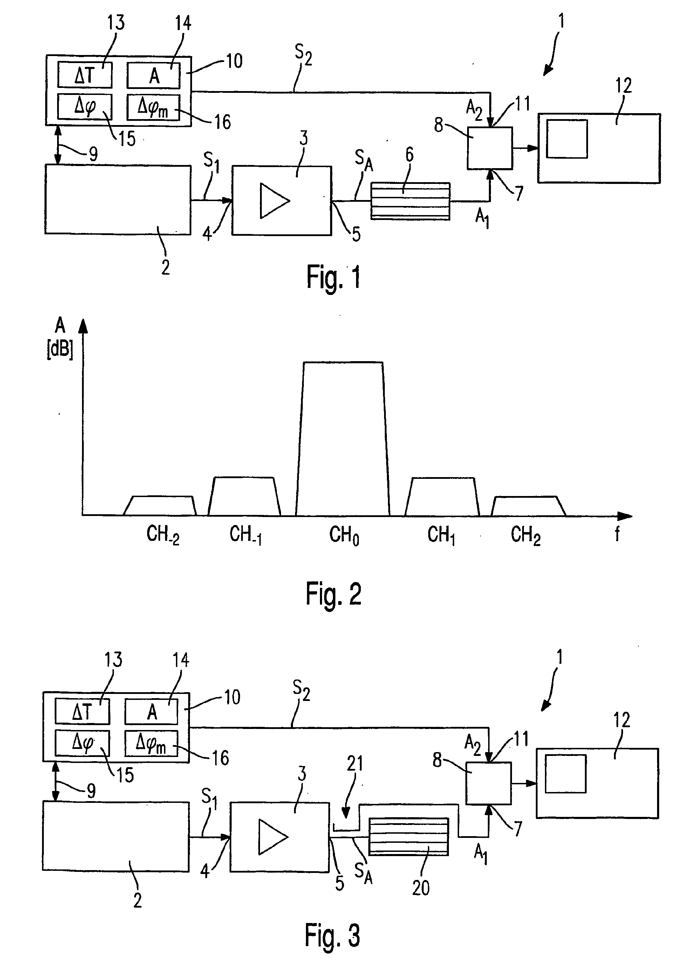

Das in Fig. 1 dargestellte Ausführungsbeispiel der erfindungsgemäßen Meßeinrichtung 1 umfaßt einen ersten Signalgenerator 2, der ein erstes Hochfrequenz S₁ erzeugt, welches dem Eingang 4 eines Meßobjekts 3 bzw. DUT (Device Under Test) zugeführt wird. Der Ausgang 5 mit dem Ausgangssignal S_{A} des Meßobjekts 3 steht im Ausführungsbeispiel über ein Dämpfungsglied 6 mit einem ersten Eingang 7 eines Signalkombinierers 8 in Verbindung. Ein mit dem ersten Signalgenerator 2 über eine Synchronisationsleitung 9 synchronisierter zweiter Signalgenerator 10 steht mit einem zweiten Eingang 11 des Signalkombinierers 8 in Verbindung. Der Signalkombinierer 8 faßt die Eingangssignale an den Eingängen 7 und 11 zu einem Gesamtsignal zusammen, das einem Signalanalysator 12 zugeführt wird. Bei dem Signalanalysator handelt es sich beispielsweise um einen Spektrumanalysator oder ein anderes geeignetes Meßgerät.

Das von dem ersten Signalgenerator 2 erzeugte Hochfrequenz-Signal S₁ und das von dem zweiten Signalgenerator 10 erzeugte Hochfrequenz-Signal S₂ sind in den Signalgeneratoren 2 und 10 mit einem geeigneten Modulations-Signal moduliert, so daß beispielsweise ein WCDMA (Wideband Code Division Multiple Access) -signal nach einem Standard der dritten Generation Mobilfunk (beispielsweise 3GPP-Standard) als Testsignal entsteht. Bei dem Meßobjekt 3 kann es sich um ein beliebiges 2-Tor handeln. Vorzugsweise werden Leistungsverstärker vermessen. Diese Leistungsverstärker sind relativ breitbandig ausgelegt, so daß eine hohe Verstärkung in dem Nutzkanal bei möglichst geringem Übersprechen in die Nachbarkanäle gegeben ist. Die Intermodulationsverzerrung in Form von Nachbarkanalleistung ACPR (Adjacent Channel Power Ratio) muß möglichst gering gehalten werden. Die Intermodulationsverzerrung, besonders in der Form der Nachbarkanalleistung ACPR, soll durch die erfindungsgemäße Meßeinrichtung als Spezifikation des zu vermessenden Leistungsverstärkers gemessen werden.

Zur Verdeutlichung zeigt Fig. 2 das typische Ausgangsspektrum eines zu vermessenden Leistungsverstärkers. Dargestellt ist der Pegel A des Ausgangssignals S_{A} des Leistungsverstärkers als Funktion der Frequenz f bei Ansteuerung nur in dem Nutzkanal CH₀. Erkennbar ist, daß der Leistungsverstärker aufgrund von Nichtlinearitäten auch stark abgeschwächte Spektren in den unmittelbaren Nachbarkanälen CH₋₁ und CH₁ sowie in den weiter entfernten Nachbarkanälen CH₋₂ und CH₂ erzeugt. Um die Nachbarkanalleistung ACPR in den Nachbarkanälen CH₋₂, CH₋₁, CH₁, CH₂ mit hoher Genauigkeit messen zu können, ist es jedoch erforderlich, daß der Leistungsverstärker, bzw. allgemein das Meßobjekt 3, nur im Nutzkanal CH₀ angesteuert wird. Ein realer Signalgenerator 2 erzeugt jedoch ebenfalls eine geringfügige Nachbarkanal-Leistungskomponente in den Nachbarkanälen, die bereits dem Eingang 4 des als Meßobjekts 3 dienenden Leistungsverstärker zugeführt werden und von diesem aufgrund der breitbandigen Auslegung mitverstärkt werden. Dies verfälscht die Messung der Nachbarkanalleistung ACPR. Es ist deshalb notwendig, die von dem Signalgenerator 2 erzeugte Nachbarkanal-Leistungskomponenten zu kompensieren.

Dazu wird erfindungsgemäß die Verwendung des mit dem ersten Signalgenerator 2 synchronisierten zweiten Signalgenerators 10 vorgeschlagen, der vorzugsweise mit dem ersten Signalgenerator 2 baugleich ist. In dem von dem zweiten Signalgenerator 10 erzeugten Hochfrequenz-Signal S₂ treten somit die gleichen Nachbarkanal-Leistungskomponenten wie in dem Hochfrequenz-signal S₁ des ersten Signalgenerators 2 auf. Das Dämpfungselement 6 ist so bemessen, daß dessen Dämpfungsfaktor etwa dem Verstärkungsfaktor des als Meßobjekt 3 dienenden Leistungsverstärkers entspricht, so daß an den Eingängen 7 und 11 des Signalkombinierers 8 etwa gleiche Signalpegel anliegen.

Der erste Signalgenerator 2 und/oder der zweite Signalgenerator 10 verfügen über Einrichtungen zum Einstellen der Zeitverzögerung, der Amplitude und der Phasenlage des von dem Signalgenerator 2 bzw. 10 erzeugten Signals. Im dargestellten Ausführungsbeispiel ist an dem zweiten Signalgenerator 10 eine Einrichtung 13 zum Einstellen der Zeitverzögerung ΔT, mit welcher das Hochfrequenz-Signal S₂ von dem zweiten Signalgenerator 10 ausgegeben wird, sowie eine Einstelleinrichtung 14 zum Einstellen der Amplitude A, mit welcher das Hochfrequenz-Signal S₂ des zweiten Signalgenerators 10 ausgegeben wird, vorhanden. Ferner kann mit einer Einstelleinrichtung 15 die Phasenlage Δϕ, mit welcher das Hochfrequenz-Signal S₂ ausgegeben wird, eingestellt werden. Das Hochfrequenz-Signal wird vorzugsweise mit einem Modulations-Signal beispielsweise in einem I/Q-Modulator moduliert. Die Phasenlage Δϕₘ des Modulations-Signals ist vorzugsweise mittels einer weiteren Einstelleinrichtung 16 einstellbar.

Die Amplitude A, mit welcher das zweite Hochfrequenz-Signal S₂ ausgegeben wird, wird so eingestellt, daß die Amplituden A₁ und A₂, mit welchen die Hochfrequenz-Signale S₁ und S₂ der Signalgeneratoren 2 und 10 an dem Signalkombinierer 8 ankommen, möglichst exakt übereinstimmen. Die Zeitverzögerung ΔT, mit welcher das zweite Hochfrequenz-Signal S₂ ausgegeben wird, wird so eingestellt, daß das Hochfrequenz-Signal S₂ von dem zweiten Signalgenerator 10 in Bezug auf das von dem ersten Signalgenerator 2 ausgegebene erste Hochfrequenz-Signal S₁ um einen Zeitversatz verzögert wird, der der Gruppenlaufzeit des Hochfrequenz-Signals S₁ durch das Meßobjekt 3 möglichst exakt entspricht. Ferner wird die Phasenlage Δϕ, mit welchem das Hochfrequenz-Signal S₂ ausgegeben wird, so eingestellt, daß das Hochfrequenz-Signal S₂ von dem zweiten Signalgenerator 10 in Bezug auf das von dem ersten Signalgenerator 2 ausgegebene Hochfrequenz-Signal S₁ um eine Phase verschoben ist, die der Phasenverschiebung durch das Meßobjekt 3 zuzüglich einem Phasenwinkel von 180° in etwa entspricht. Dadurch wird erreicht, daß die beiden Signale an den Eingängen 7 und 11 des Signalkombinierers 8 kohärent aber invertiert zueinander sind, d.h. in dieser Anmeldung definiert als : die Signale kommen gleichzeitig, mit gleicher Amplitude, aber mit einem Phasenversatz von 180° an dem Signalkombinierer 8 an. Die Signalkomponenten des Eingangssignals S₁ des Meßobjekts 3 werden daher in dem Ausgangssignal des Signal kombinierers 8 nahezu vollständig unterdrückt. Sofern in dem Eingangs signal S₁ Leistungskomponenten in den Nachbarkanälen CH₋₂, CH₋₁, CH₁, CH₂ vorhanden sind, so sind diese auch in dem Referenzsignal S₂ vorhanden und werden aufgrund der 180°-Phasenlage unterdrückt und deshalb von dem Signalanalysator 12 nicht erfaßt.

Bei einem WCDMA-Signal handelt es sich um ein breitbandig moduliertes Multiträger-Signal. Entsprechend einer erfindungsgemäßen Weiterbildung wird deshalb auch die Phasenlage des Modulations-Signals so eingestellt, daß sich an dem Signalkombinierer 8 auch für das Modulations-Signal eine 180°-Phasendifferenz ergibt. Dazu wird das Modulations-Signal, mit welchem das Hochfrequenz-Signal S₂ des zweiten Signalgenerators 10 moduliert wird, so eingestellt, daß das Modulations-Signal des zweiten Signalgenerators 10 in Bezug auf das Modulations-Signal des ersten Signalgenerators 2 um eine Phase verschoben ist, die der Modulations-Phasenverschiebung, d.h. der Phasenverschiebung des Modulations-Signals durch das Meßobjekt 3 zuzüglich 180° möglichst exakt entspricht.

Dabei ist es vorteilhaft, wenn die Phasenlage sowohl des Hochfrequenz-Signals als auch des Modulations-Signals mit möglichst kleiner Schrittweite einstellbar ist. Vorzugsweise sind die Phasenlagen Δϕ und Δϕₘ mit einer Schrittweite von weniger als 1/50, weiter bevorzugt weniger als 1/100 der Periodendauer des Hochfrequenz-Signals bzw. des Modulations-Signals einstellbar. Bei hinreichend kleiner Schrittweite ist damit eine breitbandige Signalunterdrückung von mehr 26 dB erreichbar. Dadurch ergibt sich eine Erhöhung der Meßdynamik bezüglich des Analysators 12, der mit einem geringeren Signalpegel ausgesteuert werden muß.

Fig. 3 zeigt ein zweites Ausführungsbeispiel der erfindungsgemäßen Meßeinrichtung 1. Bereits anhand von Fig. 1 beschriebene Elemente sind mit übereinstimmenden Bezugszeichen versehen, so daß sich insoweit eine wiederholende Beschreibung erübrigt.

Im Unterschied zu dem in Fig. 1 dargestellten Ausführungsbeispiel ist der Ausgang 5 des Meßobjekts 3 bei dem in Fig. 3 dargestellten Ausführungsbeispiel nicht über ein Dämpfungsglied 6 mit dem ersten Eingang 7 des Signalkombinierers 8 verbunden, sondern der Ausgang 5 des Meßobjekts 3 ist durch einen Abschlußwiderstand 20 abgeschlossen und am Ausgang 5 des Meßobjekts 3 ist ein direktionaler Koppler 21 vorgesehen, der das Ausgangssignal mit einem bestimmten Kopplungsfaktor auskoppelt. Während bei dem in Fig. 1 dargestellten Ausführungsbeispiel der Dämpfungsfaktor des Dämpfungselements 6 etwa so groß zu bemessen ist, wie der Verstärkungsfaktor des Meßobjekts 3, ist bei dem in Fig. 3 dargestellten Ausführungsbeispiel der Kopplungsfaktor des Kopplers 21 in -dB etwa so groß zu bemessen, wie der Verstärkungs-faktor in +dB des Meßobjekts 3, damit die an den Eingängen 7 und 11 anliegenden Signalamplituden A₁ und A₂ in etwa die gleiche Größenordnung haben und mit der Einstelleinrichtung 14 zur Angleichung der Amplitude A nur noch eine Feineinstellung vorgenommen werden muß.

Die Erfindung ist nicht auf die dargestellten Ausführungsbeispiele beschränkt. Beispielsweise sind auch Messungen an n-Toren mit n-1 Eingangstoren denkbar, wobei jedem Eingangstor ein unterschiedliches Eingangssignal zugeführt wird. Dabei ist für jedes Eingangstor neben dem Meß-Signalgenerator ein Referenz-Signalgenerator vorzusehen und alle Referenzsignale der Referenz-Signalgeneratoren sind dem Signalkombinierer 8, welcher dann ebenfalls als n-Tor auszubilden ist, zuzuführen.

## Patentansprüche

1. Meßeinrichtung (1) zum Messen von Intermodulationsverzerrungen eines Meßobjekts (3),
mit einem ersten Signalgenerator (2), der ein erstes Hochfrequenz-Signal (S₁) erzeugt, das einem Eingang (4) des Meßobjekts (3) mittelbar oder unmittelbar zugeführt ist,
mit einem Signalkombinierer (8), dessen erster Eingang (7) mit dem Ausgang (5) des Meßobjekts (3) mittelbar oder unmittelbar in Verbindung steht,
einem Signalanalysator (12), der mit dem Ausgang des Signalkombinierers (8) mittelbar oder unmittelbar in Verbindung steht,
und mit einem mit dem ersten Signalgenerator (2) synchronisierten zweiten Signalgenerator (10), der ein zweites Hochfrequenz-Signal (S₂) erzeugt, das einem zweiten Eingang (11) des Signalkombinierers (8) mittelbar oder unmittelbar zugeführt ist,
wobei der zweite Signalgenerator (10) das zweite Hochfrequenz-Signal (S₂) so erzeugt, daß die signale gleichzeitig, mit gleicher Amplitude, aber mit einem Phasenversatz von 180° an dem Signal-Kombinierer (8) an kommen, wobei die signal generatoren (2,10) gleiche Nachbar kanal-Leistungs Komponenten in den Nachbarkanälen erzeugen, und
wobei in dem ersten Signalgenerator (2) und/oder in dem zweiten Signalgenerator (10) eine Phasenlage (Δϕ), mit welcher das Hochfrequenz-Signal (S₁; S₂) von dem ersten bzw. zweiten Signalgenerator (2; 10) ausgegeben wird, einstellbar ist, wobei die Phasenlage (Δϕ) so eingestellt ist, daß das von dem zweiten Signalgenerator (10) ausgegebene Hochfrequenz-Signal (S₂) in Bezug auf das von dem ersten Signalgenerator (2) ausgegebene Hochfrequenz-Signal (S₁) um eine Phase verschoben ist, die der Phasenverschiebung durch das Meßobjekt (3) zuzüglich 180° in etwa entspricht, und
wobei die Schrittweite, mit welcher die Phasenlage (Δϕ) des Hochfrequenz-Signals (S₁; S₂) des zweiten Signalgenerators (10) bzw. der Signalgeneratoren (2, 10) einstellbar ist, weniger als 1/50, bevorzugt weniger als 1/100 der Periodendauer des Hochfrequenz-Signals (S₁; S₂) ist.

2. Meßeinrichtung nach Anspruch 1,
wobei in dem ersten Signalgenerator (2) und/oder in dem zweiten Signalgenerator (10) eine Zeitverzögerung (ΔT), mit welcher das Hochfrequenz-Signal (S₁; S₂) von dem ersten bzw. zweiten Signalgenerator (2; 10) ausgegeben wird, einstellbar ist, wobei die Zeitverzögerung (ΔT) so eingestellt ist, daβ das von dem zweiten Signalgenerator (10) ausgegebene Hochfrequenz-Signal (S₂) in Bezug auf das von dem ersten Signalgenerator (2) ausgegebene Hochfrequenz-Signal (S₁) um einen Zeitversatz verzögert ist, der der Gruppenlaufzeit durch das Meßobjekt (3) in etwa entspricht.

3. Meßeinrichtung nach Anspruch 1 oder 2,
wobei das Hochfrequenz-Signal (S₁, S₂) des ersten und zweiten Signalgenerators (2, 10) mit einem Modulations-Signal moduliert ist und in dem ersten Signalgenerator (2) und/oder in dem zweiten Signalgenerator (10) eine Phasenlage (Δϕₘ), mit welcher das Hochfrequenz-Signal von dem ersten bzw. zweiten Signalgenerator (2, 10) mit dem Modulations-Signal moduliert ist, einstellbar ist, wobei die Phasenlage (Δϕₘ) so eingestellt ist, daß das Modulations-Signal des zweiten Signalgenerators (10) in Bezug auf das Modulations-Signal des ersten Signalgenerators (2) um eine Phase verschoben ist, die der Modulations-Phasenverschiebung durch das Meßobjekt (3) zuzüglich 180° in etwa entspricht.

4. Meßeinrichtung nach Anspruch 3,
wobei die Schrittweite, mit welcher die, Phasenlage (Δϕₘ) des Modulations-Signals des zweiten Signalgenerators (10) bzw. der Signalgeneratoren (2, 10) einstellbar ist, weniger als 1/50, bevorzugt weniger als 1/100 der Periodendauer des Modulations-Signals ist.

5. Meßeinrichtung nach einem der Ansprüche 1 bis 4,
wobei in dem ersten Signalgenerator (2) und/oder dem zweiten Signalgenerator (10) eine Amplitude (A), mit welcher das Hochfrequenz-Signal von dem ersten bzw. zweiten Signalgenerator (2, 10) ausgegeben wird, einstellbar ist.

6. Meßeinrichtung nach einem der Ansprüche 1 bis 5,
wobei das Meßobjekt (3) ein Verstärker ist, zwischen dem Meßobjekt (3) und dem Signalkombinierer (8) ein Dämpfungsglied (6) angeordnet ist und der Dämpfungsfaktor des Dämpfungsglieds (6) so bemessen ist, daß der Signalpegel am Ausgang des Dämpfungsglieds (6) in etwa mit dem Signalpegel am Eingang (4) des Meßobjekts (3) übereinstimmt.

7. Meßeinrichtung nach einem der Ansprüche 1 bis 5,
wobei das Meßobjekt (3) ein Verstärker ist, dessen Ausgang (5) mit einem Abschlußwiderstand (20) abgeschlossen ist, und wobei zwischen dem Meßobjekt (3) und dem Abschlußwiderstand (20) ein Koppler (21) angeordnet ist, dessen Ausgang mit dem signalkombinierer (8) verbunden ist und dessen Kopplungsfaktor so bemessen ist, daß der Signalpegel am Ausgang des Kopplers (21) in etwa mit dem Signalpegel am Eingang (4) des Meßobjekts (3) übereinstimmt .

8. Meßeinrichtung nach einem der Ansprüche 1 bis 7,
wobei der Signalanalysator (12) das an dem Signalkombinierer (8) von dem ersten Signalgenerator (2) ankommende Signal aufzeichnet und den zweiten Signalgenerator (10) so ansteuert, daß dieser in Abhängigkeit von dem aufgezeichneten Signal das zweite Hochfrequenz-Signal (S₂) ausgibt.

9. Meßeinrichtung nach einem der Ansprüche 1 bis 7,
wobei der Signalanalysator (12) das an dem Signalkombinierer (8) von dem zweiten Signalgenerator (10) ankommende Signal aufzeichnet und den ersten Signalgenerator (2) so ansteuert, daß dieser in Abhängigkeit von dem aufgezeichneten Signal das erste Hochfrequenz-Signal (S₁) ausgibt.

## Claims

1. Measuring device (1) for measuring intermodulation distortions of a test object (3),
having a first signal generator (2) which produces a first high frequency signal (S₁) which is supplied indirectly or directly to an input (4) of the test object (3),
having a signal combiner (8), the first input (7) of which is connected indirectly or directly to the output (5) of the test object (3),
having a signal analyser (12) which is connected indirectly or directly to the output of the signal combiner (8),
and having a second signal generator (10) which is synchronised with the first signal generator (2) and produces a second high frequency signal (S₂) which is supplied indirectly or directly to a second input (11) of the signal combiner (8),
the second signal generator (10) producing the second high frequency signal (S₂), such that the signals arrive at the signal combiner (8) simultaneously with the same amplitude but with a phase offset of 180°, the signal generators (2, 10) producing the same neighbouring channel power components in the adjacent channels, and
in the first signal generator (2) and/or in the second signal generator (10), a phase position (Δϕ) being able to be adjusted with which the high frequency signal (S₁; S₂) is emitted by the first or second signal generator (2; 10), the phase position (Δϕ) being adjusted such that the high frequency signal (S₂) emitted by the second signal generator (10) is shifted relative to the high frequency signal (S₁) emitted by the first signal generator (2) by a phase which corresponds approximately to the phase shift through the test object (3) plus 180° and
the step size with which the phase position (Δϕ) of the high frequency signal (S₁; S₂) of the second signal generator (10) or of the signal generators (2, 10) is adjustable being less than 1/50, preferably less than 1/100 of the period duration of the high frequency signal (S₁; S₂).

2. Measuring device according to claim 1,
a time delay (ΔT) with which the high frequency signal (S₁; S₂) is emitted by the first or second signal generator (2; 10) being adjustable in the first signal generator (2) and/or in the second signal generator (10), the time delay (ΔT) being adjusted such that the high frequency signal (S₂) emitted by the second signal generator (10) is delayed relative to the high frequency signal (S₁) emitted by the first signal generator (2) by a time offset which corresponds approximately to the group running time through the test object (3).

3. Measuring device according to claim 1 or 2,
the high frequency signal (S₁; S₂) of the first and second signal generator (2, 10) being modulated with a modulation signal and, in the first signal generator (2) and/or in the second signal generator (10), a phase position (Δϕm) being able to be adjusted with which the high frequency signal from the first or second signal generator (2, 10) is modulated with the modulation signal, the phase position (Δϕm) being adjusted such that the modulation signal of the second signal generator (10) is shifted relative to the modulation signal of the first signal generator (2) by a phase which corresponds approximately to the modulation phase shift through the test object (3) plus 180°.

4. Measuring device according to claim 3,
the step size with which the phase position (Δϕm) of the modulation signal of the second signal generator (10) or of the signal generators (2, 100) is adjustable being less than 1/50, preferably less than 1/100 of the period duration of the modulation signal.

5. Measuring device according to one of the claims 1 to 4,
in the first signal generator (2) and/or in the second signal generator (10), an amplitude (A) being adjustable with which the high frequency signal is emitted by the first or second signal generator (2, 10).

6. Measuring device according to one of the claims 1 to 5,
the test object (3) being an amplifier, an attenuator (6) being disposed between the test object (3) and the signal combiner (8) and the attenuation factor of the attenuator (6) being calculated such that the signal level at the output of the attenuator (6) corresponds approximately to the signal level at the input (4) of the test object (3).

7. Measuring device according to one of the claims 1 to 5,
the test object (3) being an amplifier, the output (5) of which is terminated with a termination (20) and there being disposed, between the test object (3) and the termination (20), a coupler (21), the output of which is connected to the signal combiner (8) and the coupling factor of which is calculated such that the signal level at the output of the coupler (21) corresponds approximately to the signal level at the input (4) of the test object (3).

8. Measuring device according to one of the claims 1 to 7,
the signal analyser (12) recording the signal which arrives at the signal combiner (8) from the first signal generator (2) and actuating the second signal generator (10) such that the latter emits the second high frequency signal (S₂) dependent upon the recorded signal.

9. Measuring device according to one of the claims 1 to 7,
the signal analyser (12) recording the signal which arrives at the signal combiner (8) from the second signal generator (10) and actuating the first signal generator (2) such that the latter emits the first high frequency signal (S₁) dependent upon the recorded signal.

## Revendications

1. Dispositif de mesure (1) pour la mesure de distorsions d'intermodulation d'un objet à mesurer (3), comprenant un premier générateur de signaux (2), qui produit un premier signal à haute fréquence (S1) qui est amené directement ou indirectement à une entrée (4) de l'objet à mesurer (3),
comprenant un combinateur de signaux (8), dont la première entrée (7) est en communication directe ou indirecte avec la sortie (5) de l'objet à mesurer (3),
comprenant un analyseur de signaux (12) qui communique directement ou indirectement avec la sortie du combinateur de signaux (8),
et comprenant un second générateur de signaux (10) synchronisé avec le premier générateur de signaux (2), qui génère un second signal à haute fréquence (S2) qui est amené directement ou indirectement à une seconde entrée (11) du combinateur de signaux (8),
le second générateur de signaux (10) générant le second signal à haute fréquence (S2) de telle manière que les signaux parviennent au combinateur de signaux (8) simultanément, avec la même amplitude, mais avec un décalage de phase de 180°, les générateurs de signaux (2, 10) générant dans les canaux voisins des composantes de puissance de canaux voisins identiques, et
dans le premier générateur de signaux (2) et/ou dans le second générateur de signaux (10) il est possible de régler une position de phase (Δϕ), avec laquelle le signal à haute fréquence (S1 ; S2) est fourni par le premier ou par le second générateur de signaux (2 ; 10), ladite position de phase (Δϕ) étant ainsi réglée de façon que le signal à haute fréquence (S2) délivré par le second générateur de signaux (10) est décalé, par rapport au signal à haute fréquence (S1) délivré par le premier générateur de signaux (2), d'une phase qui correspond approximativement au décalage de phase à travers l'objet à mesurer (3) additionné de 180°, et
l'incrément duquel la position de phase (Δϕ) du signal à haute fréquence (S1 ; S2) du second générateur de signaux (10) ou respectivement des générateurs de signaux (2, 10) est réglable est inférieur à 1/50 et de préférence inférieur à 1/100 de la durée de période du signal à haute fréquence (S1 ; S2).

2. Dispositif de mesure selon la revendication 1,
dans lequel, dans le premier générateur de signaux (2) et/ou dans le second générateur de signaux (10), il est possible de régler un retard temporel (ΔT), avec lequel le signal à haute fréquence (S1 ; S2) est délivré par le premier ou par le second générateur de fréquence (2 ; 10), et le retard temporel (ΔT) est ainsi réglé que le signal à haute fréquence (S2) délivré par le second générateur de signaux (10) est retardé par rapport au signal à haute fréquence (S1) délivré par le premier générateur de signaux (2), d'un décalage temporel qui correspond approximativement au temps de parcours de groupe à travers l'objet à mesurer (3).

3. Dispositif de mesure selon la revendication 1 ou 2,
dans lequel le signal à haute fréquence (S1, S2) du premier ou du second générateur de signaux (2, 10) est modulé avec un signal de modulation et, dans le premier générateur de signaux (2) et/ou dans le second générateur de signaux (10), il est possible de régler une position de phase (Δϕm), avec laquelle le signal à haute fréquence provenant du premier ou du second générateur de signaux (2, 10) est modulé avec le signal de modulation, ladite position de phase (Δϕm) étant ainsi réglée de façon que le signal de modulation du second générateur de signaux (10) est décalé, par rapport au signal de modulation du premier générateur de signaux (2), d'une phase qui correspond approximativement au décalage de phase de modulation à travers l'objet à mesurer (3), additionné de 180°.

4. Dispositif de mesure selon la revendication 3,
dans lequel l'incrément avec lequel il est possible de régler la position de phase (Δϕm) du signal de modulation du second générateur de signaux (10), ou respectivement des générateurs de signaux (2, 10), est inférieur à 1/50, et de préférence inférieur à 1/100 de la durée de période du signal de modulation.

5. Dispositif de mesure selon l'une des revendications 1 à 4,
dans lequel, dans le premier générateur de signaux (2) et/ou dans le second générateur de signaux (10), il est possible de régler une amplitude (A) avec laquelle le signal à haute fréquence est délivré par le premier ou par le second générateur de signaux (2, 10).

6. Dispositif de mesure selon l'une des revendications 1 à 5,
dans lequel l'objet à mesurer (3) est un amplificateur, avec un circuit atténuateur (6) agencé entre l'objet à mesurer (3) et le combinateur de signaux (8), et le facteur d'atténuation du circuit amortisseur (6) est dimensionné de telle façon que le niveau du signal à la sortie du circuit atténuateur (6) coïncide approximativement avec le niveau du signal à l'entrée (4) de l'objet à mesurer (3).

7. Dispositif de mesure selon l'une des revendications 1 à 5,
dans lequel l'objet à mesurer (3) est un amplificateur dont la sortie (5) est raccordée à une résistance de terminaison (20), et un coupleur (21) est agencé entre l'objet à mesurer (3) et la résistance de terminaison (20), coupleur dont la sortie est reliée au combinateur de signaux (8) et dont le facteur de couplage est dimensionné de telle façon que le niveau du signal à la sortie du coupleur (21) coïncide approximativement avec le niveau du signal à l'entrée (4) de l'objet à mesurer (3).

8. Dispositif de mesure selon l'une des revendications 1 à 7,
dans lequel l'analyseur de signaux (12) enregistre le signal provenant du premier générateur de signaux (2) et arrivant au combinateur de signaux (8), et pilote le second générateur de signaux (10) de telle façon que celui-ci délivre le second signal à haute fréquence (S2) en fonction du signal enregistré.

9. Dispositif de mesure selon l'une des revendications 1 à 7,
dans lequel l'analyseur de signaux (12) enregistre le signal provenant du second générateur de signaux (10) et arrivant au combinateur de signaux (8), et pilote le premier générateur de signaux (2) de telle façon que celui-ci délivre le premier signal à haute fréquence (S1) en fonction du signal enregistré.
